Europäisches Patentamt

European Patent Office

Office européen des brevets

(11) Publication number: 0 276 746 B1

# EUROPEAN PATENT SPECIFICATION

(45) Date of publication of patent specification: **13.07.94**  (51) Int. Cl.⁵: **H01L  39/22**

(21) Application number: **88100786.8**

(22) Date of filing: **20.01.88**

The file contains technical information submitted after the application was filed and not included in this specification

(54) **Superconducting device.**

(30) Priority: **30.01.87 JP 18393/87**
**13.04.87 JP 88804/87**

(43) Date of publication of application:
**03.08.88 Bulletin  88/31**

(45) Publication of the grant of the patent:
**13.07.94 Bulletin  94/28**

(84) Designated Contracting States:
**DE FR GB**

(56) References cited:
**EP-A- 0 274 407**

**JAPANESE JOURNAL OF APPLIED PHYSICS, vol. 26, no. 7, part II, July 1987, pages L1211-L1213; Tokio, JP Y. HIGASHINO et al.: "Observation of the Josephson effect in Y-Ba-Cu-O compound"**

**CONDENSED MATTER, Zeitschrift für Physik B, vol. 64, September 1986, pages 189-193, Springer Verlag, Berlin, DE ; J.G. BEDNORZ et al. : "Possible high Tc superconductivity in the Ba-La-Cu-O system"**

**JOURNAL OF APPLIED PHYSICS, vol. 51, no.**

**5, May 1980, pp. 2736-2743 ; Am. Inst. of Physics, New York, US T.D. CLARK et al.: "Feasibility of hybrid Josephson field effect transistors"**

(73) Proprietor: **HITACHI, LTD.**
**6, Kanda Surugadai 4-chome**
**Chiyoda-ku, Tokyo 101(JP)**

(72) Inventor: **Nishino, Toshikazu**
**1618, Kizuki**
**Nakahara-ku**
**Kawasaki-shi Kanagawa-ken(JP)**
Inventor: **Hasegawa, Haruhiro**
**Hitachi Dai 2 Kyoshin-ryo 3-1-3**
**Higashi-koigakubo Kokubunji-shi Tokyo(JP)**
Inventor: **Kawabe, Ushio**
**1-8-46, Sakae-cho**
**Hamura-machi**
**Nishitama-gun Tokyo(JP)**

(74) Representative: **Strehl Schübel-Hopf Groening & Partner**
**Maximilianstrasse 54**
**D-80538 München (DE)**

## Description

The present invention relates to a superconducting weak link device adapted to operate at the liquid nitrogen temperature or higher temperatures, and more particularly to a high temperature superconducting device which can reduce variation in the electrical characteristics thereof attributed to manufacturing process and whose operation is stable.

As the materials of superconducting weak link devices of the high temperature operation type, materials such as $Nb_3Ge$ have heretofore been used. This technique has been discussed by H. Rogalla et al in IEEE Trans. MAG-15, 536 (1985).

In addition, a superconducting device in which electrodes exhibiting superconductivity are coupled through a semiconductor or a normal-conductor has heretofore been discussed by R. B. van Dover et al in J. Appl. Phys., vol. 52, p. 7327, 1981, in view of which the first part of claim 1 is worded. Besides, a three-terminal superconducting device in which the above superconducting device is additionally provided with means for changing the coupling between the electrodes exhibitive of the superconductivity on the basis of the field effect has been discussed by T. D. Clark et al in J. Appl. Phys., vol. 5, p. 2736, 1980.

In the prior-art superconducting devices mentioned above, the superconducting critical temperature $(T_c)$ of the constituent superconducting material is about 23 K or so. Therefore, it is impossible in principle to use the devices at higher temperatures.

In the prior art, the superconducting electrodes and the semiconductor or normal-conductor are respectively made of materials composed of the individual combinations of elements. Accordingly, the superconducting device has the structure in which, on the surface of the semiconductor or the normal-conductor, the superconductor of different material is stacked and formed. On this occasion, the characteristics of the superconductor are susceptible to the surface state of the semiconductor of the normal-conductor. Therefore, the characteristics of the device having such a structure are prone to change, and it has been difficult to reproducibly fabricate the superconducting device of this type. Besides, the superconducting critical temperature $(T_c)$ of the superconductor is at most 10 - 20 K or so. This signifies that the characteristics of the device are liable to become unstable due to the temperature change of the device.

Moreover, since the prior-art superconducting devices operate principally at the liquid helium temperature, they are cooled down to this temperature by a method of immersion in liquid helium or cooling with helium gas. The liquid helium, however, has posed the problems that it is very expensive and is uneconomical as a coolant and that it is, in itself, difficult of handling because of much lower temperatures than the room temperature.

These problems of the liquid helium have directly led to the problems that the superconducting devices themselves are uneconomical and are difficult of handling.

The object of the present invention is to provide a superconducting device which operates stably against a temperature change and which can operate at temperatures above the liquid nitrogen temperature,

which is excellent in economy and is easy of handling,

which can be readily manufactured and which exhibits uniform electrical characteristics.

These objects are met by the invention as defined in claim 1.

More specifically, a material having a composition denoted by $YBa_2Cu_3O_{7-x}$ is employed for superconducting electrodes, and an oxide material containing Y, Ba and Cu; Ba, La and Cu; or Sr and Cu is used as a semiconductor or normal-conductor, respectively. In addition, the region to become the superconducting electrodes and the region to become the semiconductor or normal-conductor are formed by making the compositions thereof different beforehand, or by changing the composition of either region later through the diffusion or injection of at least one element into the material of the regions. This is based on the fact that the electrical properties of the oxide material having the composition $YBa_2Cu_3O_{7-x}$, $Ba_{2x}La_{2(1-x)}CuO_{4(1-y)}$ or $Sr_{2x}La_{2(1-x)}CuO_{4(1-y)}$ depend upon the value $\underline{x}$.

The superconducting device of the present invention can also be realized by selecting the value $\underline{x}$ so that the superconducting critical temperature of the material of the region to become the semiconductor or normal-conductor may become lower than the operating temperature of the superconducting device (for example, 4.2 K or 77 K, or higher temperatures), or by introducing a fifth element other than the four elements which constitute the superconductors.

The material having the composition $Ba_{2x}La_{2(1-x)}CuO_{4(1-y)}$ or $Sr_{2x}La_{2(1-x)}CuO_{4(1-y)}$ exhibits a superconducting critical temperature of about 35 K when $\underline{x}$ is 0.05. Therefore, when the material of the composition in which $x = 0.05$ does not hold is previously formed as the normal-conductor or semiconductor and a superconductor layer in which $\underline{x}$ is about 0.05 and which has the high superconducting critical temperature is formed on the normal-conductor or semiconductor in a manner to be continuous thereto, the ideal interface between the superconductors and the normal-conductor or semiconductor can be obtained, and a superconducting device including superconducting weak coupling which can be established by fabricating the superconductor layer can be endowed with very uniform and reproducible characteristics. Moreover, in a case where the superconducting device stated here is additionally provided with an insulated gate electrode for an application of electric field so as to form a field-effect type superconducting transistor, a gate insulator film can be formed by oxidizing the whole sample because the superconductor layer and the normal-conductor layer (or semiconductor layer) have substantially equal oxidation rates. This is understood to be a great advantage facilitating the manufacture of the device in view of the fact that, in a conventional device which employs an Nb or Pb alloy or the like for superconducting electrodes, the material of the superconducting electrodes is more easily oxidized than a semiconductor material.

Further, as stated before, when $YBa_2Cu_3O_{7-x}$ is employed as the material which constitutes the superconducting device, the portion of the superconductors or the semiconductor or normal-conductor can be formed by diffusing or injecting at least one element. Also in this case, the interface between the portion of the superconductors and the portion of the semiconductor or normal-conductor can be formed without being exposed to the atmospheric air. Therefore, contamination etc. do not arise, and the superconducting device thus formed has uniform electrical characteristics and is excellent in reproducibility. Moreover, since the surface of the device is flattened, an insulated gate for field-effect control can be readily formed owing to the nonexistence of steps in the gate portion.

Moreover, since the superconducting critical temperature of the superconductor portion becomes higher, changes in characteristics attributed to a slight change in the operating temperature of the device decreases to be negligible, and the operation of the device can be stabilized. In this manner, according to the present invention, the superconducting device which is readily manufactured and which operates stably can be realized.

Further, for stably manufacturing the superconducting weak link device, it is required that the fabrication of a weak coupling portion be easy. The weak link device in which the superconductor - the normal-conductor - the superconductor are stacked in this order, is easy of manufacture. Since, however, the capacitance of the device increases, the uses thereof are limited. In particular, this device is unsuitable for application to an analog high-frequency device. Therefore, a device structure of the coplanar electrode type is adopted. In this case, the length between the two superconductors, namely, the size of microfabrication $\underline{d}$ must be 1 $\mu$m or less, and holding the accuracy thereof within 1 % is an indispensable technique for enhancing device characteristics and attaining uniformities in them. Meanwhile, the size of microfabrication $\underline{d}$ needs to be changed together with the operating temperature of the device for the purpose of keeping the operation of the device at the optimum. In the prior art, the operating temperatures of the devices have been the liquid helium temperature 4.2 K or in a range of about 2-6 K almost unexceptionally. It has therefore sufficed to consider them as the service temperatures and to optimize the size of microfabrication $\underline{d}$.

In contrast, in a case where the superconducting device of the present invention is used at, for example, 77 K, the size of microfabrication $\underline{d}$ the upper limit of which is assumed to be selected at about 3 - 10 times the coherence length $\xi_n$ in the normal-conductor becomes as follows:

$$d < 10 \, \xi_n \qquad (1)$$

At the dirty limit case, the following holds:

$$\xi_n \propto t^{-\frac{1}{2}} [1 + 2/\ell n(T/Tc')]^{\frac{1}{2}} \qquad (2)$$

In the above equation, $Tc'$ denotes the superconducting critical temperature of the material employed for the normal-conductor portion or semiconductor portion, and T denotes the operating temperature of the device. In the prior art, the normal-conductor portion has been made of a material such as Au or Cu the superconducting critical temperature of which can be regarded as 0 K, a semiconductor material such as Si and InAs, or a material the superconducting critical temperature of which is lower than 4.2 K being the liquid helium temperature. In this case, accordingly, Eq. (2) becomes as follows:

$$\xi_n \propto T^{-\frac{1}{2}} \qquad (3)$$

In a case where T is lower than 4.2 K, this does not pose a serious problem. However, when T is 77 K, $\xi_n$ becomes less than a quarter of the value in the case of 4.2 K, and the size of microfabrication $\underline{d}$ needs to be similarly reduced to less than $\frac{1}{4}$ in accordance with Eq. (1) in this case. Therefore, the accuracy of microfabrication needs to be raised to at least four times that of the prior art. Thus, in case of employing the same accuracy of microfabrication, variation in the dimensions of the devices exceeds four times, and variation in electrical characteristics attendant thereupon becomes conspicuous when the devices are operated at 77 K, so that the yield of the devices in manufacture lowers. For solving this problem, a material of higher $Tc'$ than in the prior art needs to be used for the normal-conductor portion or semiconductor portion. Important herein is the ratio $T/Tc'$ between T and $Tc'$ in view of Eq. (2). In order to keep constant or rather decrease the variation in the electrical characteristics by the use of a microfabrication technique equivalent to that of the prior art, the coherence length $\xi_n$ may be set at a fixed value or rendered greater, and it may be selected in view of Eq. (2) so as to satisfy the following:

$$T^{-\frac{1}{2}} [1 + 2/\ell n(T/Tc')]^{\frac{1}{2}} \geq 4.2^{-\frac{1}{2}} \qquad (4)$$

For example, in the case where the operating temperature T of the device is 77 K, $Tc'$ should desirably be 68 K or above. This lower-limit value of $Tc'$ depends upon the accuracy of the microfabrication. However, even if the accuracy of the fabrication is raised, the coherence length of the superconductors serves as one criterion for the lower limit. When the length value is the criterion, the size of microfabrication $\underline{d}$ needs to be at least 5 times this value, and the temperature $Tc'$ needs to meet:

$$\left(\frac{4.2}{T}\right)^{\frac{1}{2}} [1 + 2/\ell n(T/Tc')]^{\frac{1}{2}} \geq \frac{1}{5} \qquad (5)$$

when T is 300 K, $Tc'$ may be 102 K or above.

As understood from the foregoing description, $Tc'$ needs to satisfy Eq. (4) or Eq. (5) for the purpose of operating the superconducting weak link device at the high temperature of 77 K or above. By way of example, for operating the device at 77K, $TC'$ needs to have a finite value and may desirably be 68 K or above. In general, Eq. (5) needs to be satisfied. In the prior art, such a high-temperature operation is not taken into consideration. As another method of increasing the coherence length $\xi_n$, there is a method in which the Fermi velocity $v_F$ or carrier mean free path $\ell_n$ of a material is enlarged. Merely with this method, however, in the case where T is 300 K, devices of uniform characteristics are difficult of manufacture, and the conditions of Eqs. (4) and (5) cannot be met. In contrast, according to the present invention, the conditions of Eq. (4) and (5) can be simultaneously met. Besides, especially the problem that $\xi_n$ decreases with the increase of temperature in proportion to $T^{-\frac{1}{2}}$, so a high degree of microfabrication is necessitated to augment the variation of the electrical characteristics of devices, can be readily solved by the present invention.

According to the present invention, a device can be manufactured while the interface between a superconductor and a normal-conductor or semiconductor is kept clean, the superconducting critical temperature of the superconductor is high, and the normal-conductor portion or semiconductor portion can be formed flat. Accordingly, there is the effect that the superconducting device whose characteristics are stable, which can be reproducibly manufactured and which operates stably even against fluctuation in temperature can be realized.

**Brief Description of the Drawings:**

Fig. 1 is a sectional view showing a part of a superconducting device according to the first embodiment of the present invention;

Fig. 2 is a sectional view showing a part of a superconducting device according to the second embodiment of the present invention;

Figs. 3(a) - 3(c) are sectional views showing parts of a superconducting device according to the third embodiment of the present invention;

Figs. 4(a) - 4(c) are sectional views showing parts of a superconducting device according to the fourth embodiment of the present invention;

Fig. 5 is a setup diagram of a magneto-flux meter employing the superconducting devices of the present invention in the fifth embodiment of the present invention;

Figs. 6(a) and 6(b) are sectional views showing a part of a superconducting device according to the sixth embodiment of the present invention;

Fig. 7 is a sectional view showing a part of a superconducting device according to the seventh embodiment of the present invention; and

Fig. 8 is a sectional view showing a part of a superconducting device according to the eighth embodiment of the present invention.

Now, some examples will be described with reference to the drawings.

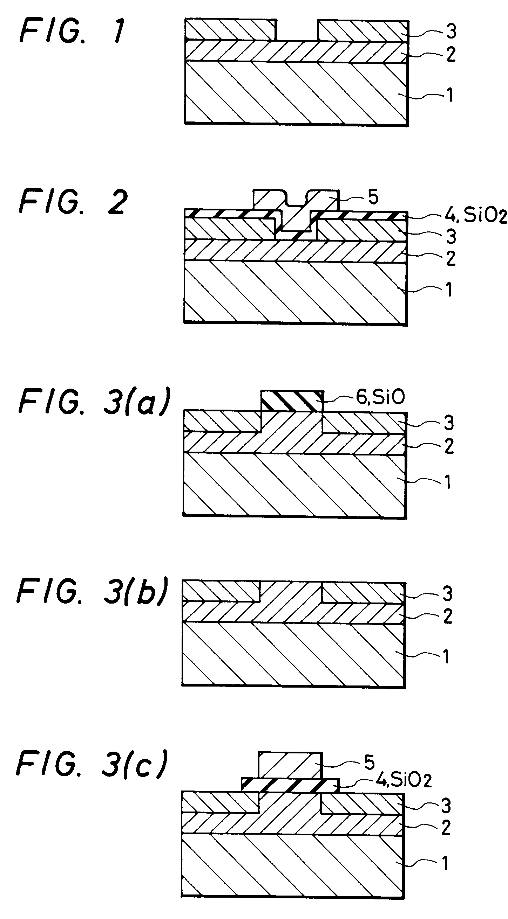

Fig. 1 is a view showing a part of a superconducting device. On a substrate 1 made of sapphire, a normal-conductor layer or semiconductor layer 2 made of a composition $Ba_{2x}La_{2(1-x)}CuO_{4(1-y)}$ (x = 0.5) and having a thickness of about 100 nm is formed by sputtering. This normal-conductor layer or semiconductor layer 2 is formed on the flat substrate 1, and the thickness thereof is uniform. A single-crystal material, for example, $SrTiO_3$ of (100) orientation may well be employed for the substrate 1. Used as a target material for the sputtering is a disc-like compact into which oxides of Ba, La and Cu pulverized and mixed are shaped by a press. A mixed gas consisting of Ar and $O_2$ is used during the sputtering, and the value $\underline{y}$ can be changed by altering the partial pressure of oxygen on this occasion. Subsequently, a superconductor layer 3 of $Ba_{2x}La_{2(1-x)}CuO_{4(1-y)}$ (x = 0.05) is formed similarly by sputtering and without breaking vacuum. A pattern of photoresist is formed on the surface of this superconductor layer 3, and using it as a mask, sputter-etching with Ar ions is carried out to remove a part of the superconductor layer 3, whereby two superconducting electrodes opposing to each other are formed. In consequence, a space is defined between the two superconducting electrodes. In this way, a diode type superconducting device having a structure of the superconductor - the normal-conductor (semiconductor) - the superconductor can be obtained. In this case, since the normal-conductor layer 2 and the superconductor layer 3 are continously formed, the interface between both the layers is free from contamination etc. and can be formed in an ideal state. Accordingly, the device is excellent in the uniformity and reproducibility of electrical characteristics. Another effect is that, since the material of high superconducting critical temperature is used for the superconductor layer, the operation of the device is stabilized.

Next, a second example will be described with reference to Fig. 2. The upper surface of the superconducting device in Fig. 1 is heated and oxidized in pure oxygen, to form an insulator film 4 being 20 - 80 nm thick. Subsequently, a gate electrode 5 made of an Al evaporated film having a thickness of about 3000 nm is formed between the two superconducting electrodes 3. This gate electrode controls current which flows across the two superconducting electrodes. Thus, a transistor type superconducting device with three terminals can be realized. The present example shown in Fig. 2 concerns the superconducting device of the field effect type having the gate electrode. In this case, likewise to the case of Fig. 1, the normal-conductor layer 2 and the superconductor layer 3 are made of the same elements, so that the growth rate of the oxide film 4 is substantially uniform. Accordingly, the superconducting device the oxide film 4 of which has a uniform thickness can be readily realized.

The third example will be described with reference to Figs. 3(a) - 3(c). In the examples of Figs. 1 and 2, the normal-conductor layer 2 and the superconductor layer 3 have been individually formed by making the compositions of the materials thereof slightly different. The same structure can also be realized in such a way that only one of the normal-conductor layer 2 and the superconductor layer 3 is formed beforehand, whereupon the other is formed using the diffusion or injection of an element or elements which constitutes or constitute the formed material. That is, the present example corresponds to a case where the normal-conductor layer 2 is previously formed and where the composition thereof is subsequently changed. In Fig. 3(a), a normal-conductor layer 2 made of a composition $Ba_{2x}La_{2(1-x)}CuO_{4(1-y)}$ (x = 0.05, y > 0) and having a thickness of about 200 nm is formed on a substrate 1 of sapphire by sputtering. Subsequently, an insulator film 6 of SiO having a thickness of about 250 nm is formed by evaporation, and using it as a mask, oxygen ions are injected to form a superconductor layer 3 the composition of which is of y = 0. Thereafter, the insulator film 6 is removed. Then, as shown in Fig. 3, the diode type superconducting device having the same structure as in Fig. 1 can be realized. An insulator film 4 made of $SiO_2$ and having a thickness of about 20 - 80 nm is formed on the upper surface of this device by sputtering. Lastly, a gate electrode 5 made of an Al evaporated film about 300 nm thick is formed on the part of the insulator film 4 between the two superconductors 3. Then, as shown in Fig. 3(c), the superconducting device constructed similarly to the example of Fig. 2, namely, the field effect type superconducting transistor can be fabricated.

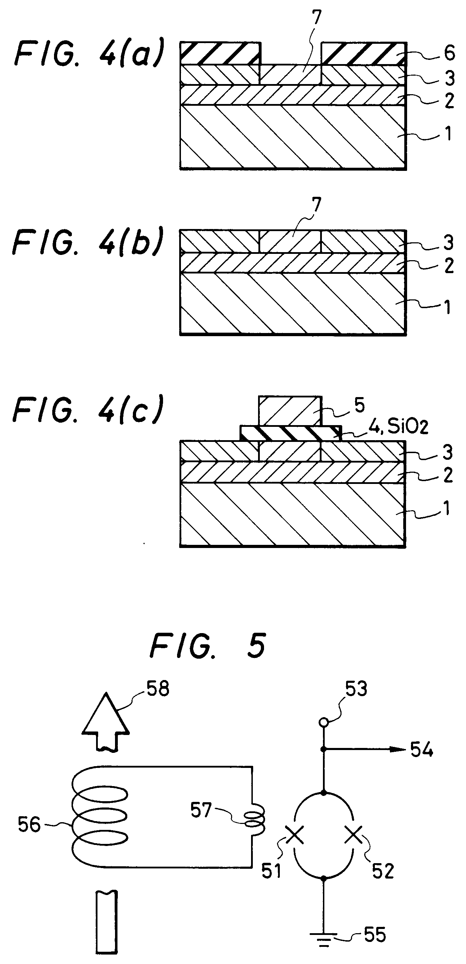

The fourth example will be described with reference to Figs. 4(a) - 4(c). Whereas the third example in Figs. 3(a) - 3(c) has previously formed the normal-conductor layer 2 and thereafter changed its composition to form the superconductor layer 3, the present example forms the superconductor layer 3 in advance and diffuses or injects atoms thereinto to form the normal-conductor layer 2. On a substrate 1 made of sapphire, a normal-conductor layer 2 having a composition $Ba_{2x}La_{2(1-x)}CuO_{4(1-y)}$ (x = 0.05, y > 0) and a superconductor layer 3 having the same composition except y = 0 are respectively formed to thicknesses of about 100 nm, whereupon using as a mask the same insulator film 6 of $SiO_2$ as in Fig. 3(a), Ba ions are injected to form a normal-conductor layer 7 (Fig. 4(a)). By removing the insulator film 6, the diode type superconducting device of the same structure as in Fig. 3 (b) can be obtained (Fig. 4(b)). In addition, by adding an oxide film 4 and a gate electrode 5 as shown in Fig. 4 (c), the field effect type superconducting device of the same structure as in Fig. 3(c) can be obtained.

Next, the fifth example will be described with reference to Fig. 5. The present embodiment is a magneto-flux meter which employs the diode type superconducting devices 51 and 52 of the present invention. The two superconducting devices 51 and 52 are connected with each other so as to form a closed loop. This closed loop is supplied with electric power from a power source terminal 53. Shown at numeral 55 is a ground point. The detection signal of the closed loop is delivered from an output end 54. A detecting coil 56 detects a magnetic flux to-be-measured 58. Connected to the detecting coil 56 is a coupling coil 57, which feeds the closed loop with a magnetic flux corresponding to the magnetic flux 58. Superconductor parts included in this magneto-flux meter, that is, wiring to the power source terminal 53 as well as the output terminal 54, the detecting coil 56, the coupling coil 57, and wiring between both the coils 56, 57 are all made of thin films of a superconducting material having a composition $Ba_{2x}La_{2(1-x)}CuO_{4(1-y)}$ (x = 0.05). As a result, the detecting coil 56 of this magneto-flux meter operates at temperatures up to 35 K. Also, as the whole magneto-flux meter, characteristics fluctuate little due to fluctuation in temperature, and a stable operation can be realized.

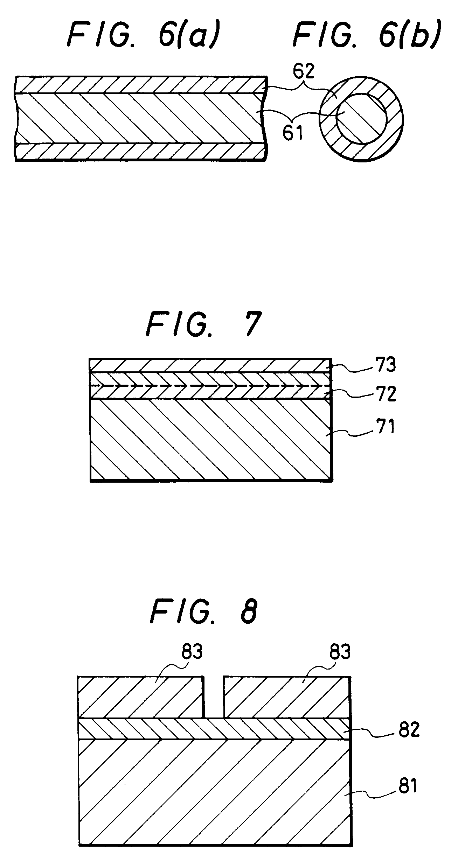

The sixth example will be described with reference to Figs. 6(a) and 6(b). A Cu alloy containing several wt.% to about 18 wt.% of La is sintered in vacuum, and is turned into a solid solution. Thereafter, the solid solution is rolled or wire-drawn into a desired wire rod 61. A solution in which the powder of the carbonate or acetate of Ba (or Sr) dissolved in pentyl acetate is applied on the surface of the wire rod 61 to a thickness of several $\mu$m by spray coating, and it is sufficiently dried. Thereafter, the resulting wire rod is slowly heat-treated at 900 °C in a reduced-pressure atmosphere for about 6 hours. The surface of the wire rod is subsequently washed with dilute acetic acid, whereby a superconductor layer 62 made of $(La_{1-x}Ba_x)$-$_2CuO_{4(1-y)}$ (or $(La_{2(1-x)} Sr_{2x}CuO_4)$ having the $K_2NiF_4$ crystalline structure is formed on the surface of the Cu alloy. The superconducting critical temperature of the superconductor layer 62 is 20 - 30 K.

The superconducting wire material thus fabricated can be used for the detecting coil 56 in the embodiment of the present invention shown in Fig. 5. Besides, by manufacturing a wire material in accordance with such a construction, the continuous wire material of high critical temperature can be formed, so that the present wire material can be used for a superconducting magnet, a power transmission line, etc.

The present example has employed the Cu-La alloy in the shape of the wire rod. Needless to say, however, when the Cu-La alloy in the shape of a thin film is employed, the construction of the first embodiment shown in Fig. 1 can be readily realized by forming the superconductor layer on the surface of the thin film and microfabricating the layer.

Next, the seventh example will be described with reference to Fig. 7. On an insulator substrate 71 of $SiO_2$, $Al_2O_3$ orthe like, La is first vacuum-evaporated, and Cu is subsequently vacuum-evaporated, whereby the substrate 71 is covered with the double-layer film 72 of La-Cu which is about 300 nm think as a whole. On this occasion, the ratio between the thicknesses of the Cu/La layers is set at about 10/64 or above. $BaCO_3$ or $SrCO_3$ powder dissolved in pentyl acetate is applied on the upper surface of the resulting structure by spray coating, and is dried. Thereafter, the resulting structure is slowly heated at 900 °C in a reduced-pressure atmosphere for 1 hour, whereupon the surface thereof is washed with dilute acetic acid. Then, a superconductor layer 73 of $Ba_{2x}La_{2(1-x)}CuO_{4(1-y)}$ or $Sr_{2x}La_{2(1-x)} CuO_{4(1-y)}$ having the $K_2NiF_4$ crystalline structure can be formed on the surface. The superconductor layer 73 has a high superconducting critical temperature of 20 - 30 K, and by the microfabrication thereof, the construction of the first example shown in Fig. 1 can be readily realized. Further, it is to be understood that the superconducting device having the construction shown in Fig. 2 can be readily realized by forming an insulator film and a gate electrode.

Moreover, when the double-layer film 72 of La-Cu is fabricated into a pattern beforehand, the superconductor having the $K_2NiF_4$ structure can be formed on only the corresponding part, so that as superconducting wire or circuit of high superconducting critical temperature can be readily manufactured.

In the superconductors employed in the foregoing examples, La may well be replaced with Y, Sc, Sm, Eu, Er, Gd, Ho, Yb, Nd, Pr, Lu or Tb. Even when Ba or Sr is replaced with Ca, Mg or Ra, the objects of the present invention can be achieved.

Next, an embodiment of the present invention will be described with reference to Fig. 8. On a substrate 81 made of sapphire, a thin film for normal conduction 82 made of $Ba_{2x}La_{2(1-x)}CuO_{4(1-y)}$ (x = 0.05) and having a thickness of about 100 nm is formed by sputtering. A method for the formation may be the same as described in the example in Fig. 1. The superconducting critical temperature $Tc'$ of the normal-

conducting thin film 82 is 39 K. Subsequently, a superconducting thin film 83 of a composition $YBa_2Cu_3O_{7-x}$ at a thickness of about 200 nm is formed similarly by sputtering. The superconducting critical temperature TC of the superconducting thin film 83 is 94 K. A pattern of photoresist is formed on the film 83, and using it as a mask, sputter-etching with Ar ions is carried out to process the superconducting thin film 83 into two superconducting electrodes opposing to each other. In this way, the structure of the superconductor - the normal-conductor (second superconductor) - the superconductor can be realized. In the present embodiment, the superconducting critical temperature Tc' of the second superconductor functioning as the normal-conductor has been 39 K, but it is a matter of course that the temperature may well be a lower value within the range fulfilling Eq. (5). The composition of the superconducting thin film 83 is not restricted to the aforementioned one, either. Regarding the constituent elements, it is needless to say that Ba may well be replaced with Sr, Ca, Mg or Ra and that Y may well be replaced with one or more elements selected from the group consisting of elements La, Se, Sm, Eu, Gd, Ho, Yb, Nd, Pr, Lu and Tb. Such examples are listed in Table 1:

## Table 1

| Semiconductor (Normal-conductor) | | Superconductor | |
|---|---|---|---|
| $EuBa_2Cu_3O_{7-y}$ | $y > 0.5$ | $EuBa_2Cu_3O_{7-y}$ | $0 < y < 0.5$ |
| $EuSr_2Cu_3O_{7-y}$ | $y > 0.5$ | $EuSr_2Cu_3O_{7-y}$ | $0 < y < 0.5$ |
| $HoBa_2Cu_3O_{7-y}$ | $y > 0.5$ | $HoBa_2Cu_3O_{7-y}$ | $0 < y < 0.5$ |
| $HoSr_2Cu_3O_{7-y}$ | $y > 0.5$ | $HoSr_2Cu_3O_{7-y}$ | $0 < y < 0.5$ |
| $GdBa_2Cu_3O_{7-y}$ | $y > 0.5$ | $GdBa_2Cu_3O_{7-y}$ | $0 < y < 0.5$ |
| $GdSr_2Cu_3O_{7-y}$ | $y > 0.5$ | $GdSr_2Cu_3O_{7-y}$ | $0 < y < 0.5$ |
| $YbBa_2Cu_3O_{7-y}$ | $y > 0.5$ | $YbBa_2Cu_3O_{7-y}$ | $0 < y < 0.5$ |
| $YbSr_2Cu_3O_{7-y}$ | $y > 0.5$ | $YbSr_2Cu_3O_{7-y}$ | $0 < y < 0.5$ |
| $TbBa_2Cu_3O_{7-y}$ | $y > 0.5$ | $TbBa_2Cu_3O_{7-y}$ | $0 < y < 0.5$ |
| $TbSr_2Cu_3O_{7-y}$ | $y > 0.5$ | $TbSr_2Cu_3O_{7-y}$ | $0 < y < 0.5$ |
| $NdCa_2Cu_3O_{7-y}$ | $y > 0.5$ | $NdCa_2Cu_3O_{7-y}$ | $0 < y < 0.5$ |
| $NdSr_2Cu_3O_{7-y}$ | $y > 0.5$ | $NdSr_2Cu_3O_{7-y}$ | $0 < y < 0.5$ |
| $SmBa_2Cu_3O_{7-y}$ | $y > 0.5$ | $SmBa_2Cu_3O_{7-y}$ | $0 < y < 0.5$ |
| $SmSr_2Cu_3O_{7-y}$ | $y > 0.5$ | $SmSr_2Cu_3O_{7-y}$ | $0 < y < 0.5$ |
| $Ba_{2x}La_{2(1-x)}CuO_{4(1-y)}$ | $x > 0.05$ | $Ba_{2x}La_{2(1-x)}CuO_{4(1-y)}$ | $x = 0.05$ |
| $Sr_{2x}La_{2(1-x)}CuO_{4(1-y)}$ | $x > 0.05$ | $Sr_2La_{2(1-x)}CuO_{4(1-y)}$ | $x = 0.05$ |

$$Ca_{2x}La_{2(1-x)}CuO_{4(1-y)} \qquad x > 0.05$$

$$Ba_{2x}Y_{2(1-x)}CuO_{4(1-y)} \qquad x > 0.05$$

$$Sr_{2x}Y_{2(1-x)}CuO_{4(1-y)} \qquad x > 0.05$$

$$Ba_{2x}Eu_{2(1-x)}CuO_{4(1-y)} \qquad x > 0.05$$

$$Sr_{2x}Eu_{2(1-x)}CuO_{4(1-y)} \qquad x > 0.05$$

$$Ba_{2x}Eu_{2(1-x)}CuO_{4(1-y)} \qquad x > 0.05$$

$$Ca_{2x}La_{2(1-x)}CuO_{4(1-y)} \qquad x = 0.05$$

$$Ba_{2x}Y_{2(1-x)}CuO_{4(1-y)} \qquad x = 0.05$$

$$Sr_{2x}Y_{2(1-x)}CuO_{4(1-y)} \qquad x = 0.05$$

$$Ba_{2x}Eu_{2(1-x)}CuO_{4(1-y)} \qquad x = 0.05$$

$$Sr_{2x}Eu_{2(1-x)}CuO_{4(1-y)} \qquad x = 0.05$$

$$Ba_{2x}Eu_{2(1-x)}CuO_{4(1-y)} \qquad x = 0.05$$

**Claims**

1. A superconducting device comprising:
   a substrate (1);
   a semiconductor or normal-conductor body (2) formed on said substrate (1); and
   two superconductor bodies (3) formed in contact with said semiconductor or normal-conductor body (2) and spaced from each other so as to form a superconducting weak coupling through said semiconductor or normal-conductor body (2),
   characterized in that
   the two superconductor bodies (3) are made of an oxide of perovskite or $K_2NiF_4$ type crystalline structure which contains at least one element selected from the group consisting of Ba and Sr; at least one of the elements Y, Sm, Eu, Er, Gd, Ho, Yb and Lu; Cu; and O, such that the transition temperature ($T_c$) of the material forming said superconductor bodies (3) is at or above the boiling temperature of liquid nitrogen; and
   said semiconductor or normal-conductor body (2) is made of an oxide having the same elements and crystalline structure as, but a different composition than the two superconductor bodies (3).

2. The superconducting device of claim 1, wherein said superconductor bodies (3) have a composition of $YBa_2Cu_3O_{7-x}$.

3. The superconducting device of claim 1 or 2, further including control means (5) for controlling the current flowing between said superconductor bodies (3), which control means (5) is formed on said semiconductor or normal-conductor body (2) and is separated therefrom by a 20 to 80nm thick electric insulator film (4).

4. A method of fabricating a superconducting device according to claim 1 or 2, comprising the steps of
   preparing the substrate (1);
   disposing a semiconductor or a normal-conductor layer (2) on the substrate (1),
   injecting or diffusing oxygen ions into two portions of the semiconductor or the normal-conductor layer to change the composition thereof, thereby to form two superconductor layers (3).

5. A method of fabricating a superconducting device according to claim 1 or 2, comprising the steps of:
   preparing the substrate (1);
   disposing a semiconductor or a normal-conductor layer (2) on the substrate (1);
   disposing a superconductor layer (3) on the semiconductor or the normal-conductor layer (2); and
   injecting or diffusing ions into a portion of the superconductor layer (3) to change composition thereof, thereby to form the semiconductor or normal-conductor body (7).

6. Use of the superconducting device of any of claims 1 to 3, at a temperature wherein the following equation is fulfilled:

$$T^{-\frac{1}{2}} [1 + 2/\ell n(T/Tc')]^{-\frac{1}{2}} \geq \tfrac{1}{5} (4.2)^{-\frac{1}{2}}$$

with Tc' denoting the superconducting critical temperature of said semiconductor or normal-conductor body (2).

7. Use of two interconnected superconducting devices (51, 52), each according to claim 1 or 2, in a closed loop of a magneto-flux meter, which further comprises

power source terminals (53, 55) which supply electric power to said closed loop incorporated thereacross;

an output terminal (54) which delivers a detection signal from said closed loop;

a detecting coil (56) which detects a magnetic flux to-be-measured; and

a coupling coil (57) which is connected to said detecting coil (56) and which feeds said closed loop with a magnetic flux proportional to the magnetic flux to-be-measured;

said detecting coil (56), said coupling coil (57), and wiring among the various constituents being made of thin films of an oxide which has the same composition as that of said superconducting devices (51, 52).

## Patentansprüche

1. Supraleiteranordnung umfassend:

ein Substrat(1);

einen auf dem Substrat (1) gebildeten halbleitenden oder normalleitenden Körper (2); und

zwei supraleitende Körper (3), die in Kontakt mit dem halbleitenden oder normalleitenden Körper (2) gebildet sind und derartig voneinander beabstandet sind, daß sie eine supraleitende schwache Kopplung über den halbleitenden oder normalleitenden Körper (2) bilden,

dadurch gekennzeichnet, daß

die zwei supraleitenden Körper (3) aus einem Oxid mit einer Kristallstruktur vom Perowskit- oder $K_2NiF_4$-Typ gebildet sind, das zumindest ein Element aus der aus Ba und Sr bestehenden Gruppe, zumindest eines der Elemente Y, Sm, Eu, Er, Gd, Ho, Yb und Lu; Cu; und O enthält, so daß die Umwandlungstemperatur ($T_c$) des die supraleitenden Körper (3) bildenden Materials bei oder oberhalb der Siedetemperatur von flüssigem Stickstoff liegt; und

der halbleitende oder normalleitende Körper (2) aus einem Oxid mit den gleichen Elementen und der gleichen Kristallstruktur wie die zwei supraleitenden Körper (3) besteht, jedoch eine andere Zusammensetzung aufweist.

2. Supraleiteranordnung nach Anspruch 1, wobei die supraleitenden Körper (3) die Zusammensetzung $YBa_2Cu_3O_{7-x}$ aufweisen.

3. Supraleiteranordnung nach Anspruch 1 oder 2, ferner umfassend Regelungsmittel (5) zur Regelung des zwischen den supraleitenden Körpern (3) fließenden Stromes, wobei das Regelungsmittel (5) auf dem halbleitenden oder normalleitenden Körper (2) gebildet ist und von diesem durch einen 20 bis 80 nm dicken elektrisch isolierenden Film (4) getrennt ist.

4. Verfahren zur Herstellung einer Supraleiteranordnung nach Anspruch 1 oder 2, umfassend die Schritte:

Vorbereiten des Substrates (1);

Aufbringen einer halbleitenden oder normalleitenden Schicht (2) auf dem Substrat (1),

Injizieren oder Diffundieren von Oxidionen in zwei Abschnitte der halbleitenden oder normalleitenden Schicht zur Änderung ihrer Zusammensetzung, um dadurch zwei supraleitende Schichten (3) zu bilden.

5. Verfahren zur Herstellung einer Supraleiteranordnung nach Anspruch 1 oder 2, umfassend die Schritte:

Vorbereiten des Substrates (1);

Aufbringen einer halbleitenden oder normalleitenden Schicht (2) auf dem Substrat (1);

Aufbringen einer supraleitenden Schicht (3) auf der halbleitenden oder normalleitenden Schicht (2); und

Injizieren oder Diffundieren von Ionen in einen Abschnitt der Supraleitenden Schicht (3) zur Änderung ihrer Zusammensetzung, um dadurch den halbleitenden oder normalleitenden Körper (7) zu bilden.

6. Verwendung der Supraleiteranordnung nach einem der Ansprüche 1 bis 3 bei einer Temperatur, bei der die folgende Gleichung erfüllt ist:

$$T^{-\frac{1}{2}} \, [1 \, + \, 2/\ell n(T/Tc')]^{-\frac{1}{2}} \geqq \tfrac{1}{5} \, (4.2)^{-\frac{1}{2}}$$

wobei Tc' die kritische Temperatur für die Supraleitung des halbleitenden oder normalleitenden Körpers (2) bezeichnet.

7. Verwendung von zwei miteinander verbundenen Supraleiteranordnungen (51, 52), jede gemäß Anspruch 1 oder 2, in einer geschlossenen Schleife eines Magnetflußgeräts, welches ferner umfaßt:

Stromversorgungsanschlüsse (53, 55), die elektrische Energie an die dazwischen angeordnete geschlossene Schleife liefern;

einen Ausgangsanschluß (54), der ein Erfassungssignal von der geschlossenen Schleife liefert;

eine Erfassungsspule (56), die einen zu messenden magnetischen Fluß erfaßt; und

eine Koppelspule (57), die mit der Erfassungsspule (56) verbunden ist und die der geschlossenen Schleife einen magnetischen Fluß zuführt, der proportional ist zu dem zu messenden magnetischen Fluß;

wobei die Erfassungsspule (56), die Koppelspule (57) und die Verdrahtung zwischen den verschiedenen Bauteilen aus dünnen Filmen eines Oxides bestehen, das die gleiche Zusammensetzung hat wie die Supraleiteranordnungen (51, 52).

**Revendications**

1. Dispositif supraconducteur comprenant :

un substrat (1);

un corps semiconducteur ou normalement conducteur (2) formé sur ledit substrat (1); et

deux corps supraconducteurs (3) formés de manière à être en contact avec ledit corps semiconducteur ou normalement conducteur (2) et espacés l'un de l'autre de manière à former un couplage faible de supraconduction par l'intermédiaire dudit corps semiconducteur ou normalement conducteur (2), caractérisé en ce que

les deux corps supraconducteurs (3) sont formés par une structure cristalline de type oxyde de pérovskite ou $K_2NiF_4$, qui contient au moins un élément choisi dans le groupe constitué de Ba et Sr; au moins l'un des éléments Y, Sm, Eu, Er, Gd, Ho, Yb et Lu; Cu; et O, de sorte que la température de transition ($T_c$) du matériau formant lesdits corps supraconducteur (3) est égale ou supérieure à la température d'ébullition de l'azote liquide; et

ledit corps semiconducteur ou normalement semiconducteur (2) est formé d'un oxyde possédant les mêmes éléments et la même structure cristalline que les deux corps supraconducteurs (3), mais avec une composition différente de ces derniers.

2. Dispositif supraconducteur selon la revendication 1, selon lequel les dispositifs supraconducteurs (3) possèdent une composition $YBa_2Cu_3O_{7-x}$.

3. Dispositif supraconducteur selon la revendication 1 ou 2, comportant en outre des moyens de commande (5) pour commander le courant circulant entre lesdits corps supraconducteurs (3), lesquels moyens de commande (5) sont formés sur ledit corps semiconducteur ou normalement conducteur (2) et en étant séparés par une pellicule électriquement isolante (14) possédant une épaisseur de 20 à 80 nm.

4. Procédé pour fabriquer un dispositif supraconducteur selon la revendication 1 ou 2, comprenant les étapes consistant à :

préparer le substrat (1);

disposer une couche semiconductrice ou une couche normalement conductrice (2) sur le substrat (1),

    injecter ou faire diffuser des ions oxygène dans deux parties de la couche semiconductrice et de la couche normalement conductrice pour modifier sa composition, de manière à former deux couches supraconductrices (3).

5. Procédé pour fabriquer un dispositif supraconducteur selon la revendication 1 ou 2, comprenant les étapes consistant à :

    préparer le substrat (1);

    disposer une couche normalement conductrice (2) sur le substrat (1);

    disposer une couche supraconductrice (3) sur la couche semiconductrice ou sur la couche normalement conductrice (2); et

    injecter ou faire diffuser des ions dans une partie de la couche supraconductrice (3) pour modifier sa composition, de manière à former le corps semiconducteur ou normalement conducteur (7).

6. Utilisation du dispositif supraconducteur selon l'une quelconque des revendications 1 à 3, à une température à laquelle l'équation suivante est satisfaite :

$$T^{-\frac{1}{2}} [1 + 2/\ell n(T/Tc')]^{-\frac{1}{2}} \geq \frac{1}{5} (4,2)^{-\frac{1}{2}}$$

Tc' désignant la température critique de supraconduction dudit corps semiconducteur ou normalement conducteur (2).

7. Utilisation de deux dispositifs supraconducteurs interconnectés (51,52), chacun selon la revendication 1 ou 2, dans une boucle fermée d'un appareil de mesure du flux magnétique, qui comprend en outre

    des bornes (53, 55) d'une source d'alimentation, qui appliquent une alimentation électrique à ladite boucle fermée incorporée entre ces bornes;

    une borne de sortie (54) qui délivre un signal de détection à partir de ladite boucle fermée;

    une bobine de détection (56) qui détecte un flux magnétique pouvant être mesuré; et

    une bobine de couplage (57) qui est raccordée à ladite bobine de détection (56) et alimente ladite boucle fermée avec un flux magnétique proportionnel au flux magnétique devant être mesuré;

    ladite bobine de détection (56), ladite bobine de couplage (57) et le câblage situé entre les différents constituants étant constitués par de minces pellicules d'un oxyde, qui possède la même composition que celle desdits dispositifs supraconducteurs (51, 52).

FIG. 1

FIG. 2

FIG. 3(a)

FIG. 3(b)

FIG. 3(c)

FIG. 4(a)

FIG. 4(b)

FIG. 4(c)

FIG. 5

## FIG. 6(a)    FIG. 6(b)

62

61

## FIG. 7

73
72
71

## FIG. 8

83    83

82

81